# EUROPEAN PATENT APPLICATION

(11) **EP 3 445 038 A1**
(43) Date of publication of application: **20.02.2019**
(21) Application number: 18188962.7
(22) Date of filing: 14.08.2018
(51) Int. Cl.: H04N 5/369, H01L 27/146, H04N 5/359

(54) **STACKED PHOTO SENSOR ASSEMBLY WITH PIXEL LEVEL INTERCONNECT**

(30) Priority: 16.08.2017 US 201762546476 P; 01.11.2017 US 201715801216; 07.08.2018 WO PCT/US2018/045673
(71) Applicant: Facebook Technologies, LLC, Menlo Park, CA 94025 (US)
(72) Inventor: LIU, Xinqiao, Menlo Park, CA California 94025 (US)
(74) Representative: Schröer, Gernot H.

(57) **Abstract**

Embodiments relate to a stacked photo sensor assembly where two substrates that are stacked vertically. The two substrates are connected via interconnects at a pixel level to provide a signal from a photodiode at a first substrate to circuitry on a second substrate. The circuitry on the second substrate performs operations that were conventionally performed on first substrate. By stacking the first and second substrates, the photo sensor assembly can be made more compact while increasing or at least retaining the photodiode fill factor of the photo sensor assembly.

## Description

### BACKGROUND

The present disclosure relates generally to optical sensors, and more particularly, to backside illumination optical sensors for machine vision.

Optical sensors are electronic detectors that convert light into an electronic signal. In photography, a shutter is a device that allows light to pass for a determined period of time, exposing the optical sensors to the light in order to capture an image of a scene. Rolling shutter is a method of image capture in which a still picture or each frame of a video is captured by scanning across the scene rapidly in a horizontal or vertical direction. That is, every pixel is not captured at the same time; pixels from different rows are captured at different times. Rolling shutter is mostly used in cell phone sensors. Machine vision, in contrast, uses global shutter where every pixel is captured at the same time.

Most optical sensors use backside illumination. A back-illuminated sensor is a type of digital optical sensor that uses a particular arrangement of imaging elements to increase the amount of light captured, improving low-light performance. A traditional front-illuminated digital camera is constructed similarly to the human eye, with a lens at the front and photodetectors at the back. This orientation of the sensor places the active matrix of the digital camera sensor, a matrix of individual picture elements, on its front surface and simplifies manufacturing. The matrix and its wiring, however, reflect some of the light, reducing the signal that is available to be captured. A back-illuminated sensor contains the same elements, but arranges the wiring behind the photocathode layer by flipping the silicon wafer during manufacturing and then thinning its reverse side so that light can hit the photocathode layer without passing through the wiring layer, thereby improving the chance of an input photon being captured.

However, there are problems associated with conventional back-illuminated sensors. Storage is exposed to light, which causes higher leakage. Also, the photodiode fill factor, or the ratio of light-sensitive area of a pixel to total pixel area, is low. A large fill factor is ideal because more of the pixel area is used for photocollection, which simultaneously improves signal-to-noise ratio (SNR) and dynamic range. The dynamic range of an image sensor measures how wide of a range of lighting the sensor can accurately capture. The wider the dynamic range of the image sensor, the more details can be shown under low light conditions and thus the more versatile the imaging system becomes. The SNR of an image sensor measures the ratio between the signal and its associated noise. An image sensor with low SNR will have a high amount of noise appearing in the captured image. An image sensor with high SNR can be used in low light conditions. Due to problems associated with existing back-illuminated sensors, an improved photo assembly would be desirable.

### SUMMARY

Embodiments relate to a pixel of a photo sensor with stacked substrates and a pixel level interconnect that connects circuits in the stacked substrates. The pixel may include a portion of a first substrate, a portion of a second substrate having a circuit for processing a signal from the first substrate; and the pixel level interconnect. The portion of the first substrate includes a photodiode for detecting light, and a diffusion well associated with the photodiode to store photocharge from the photodiode. The amount of charge stored in the diffusion well depends on duration and intensity of the light incident on the photodiode. The pixel level interconnect connects the second diffusion well of the first substrate to the circuit of the second substrate to carry the signal from the second diffusion well to the circuit.

Embodiments according to the invention are in particular disclosed in the attached claims directed to a pixel of a photo sensor, and a method, , wherein any feature mentioned in one claim category, e.g. pixel, can be claimed in another claim category, e.g. method, storage medium, system and computer program product as well. The dependencies or references back in the attached claims are chosen for formal reasons only. However any subject matter resulting from a deliberate reference back to any previous claims (in particular multiple dependencies) can be claimed as well, so that any combination of claims and the features thereof is disclosed and can be claimed regardless of the dependencies chosen in the attached claims. The subject-matter which can be claimed comprises not only the combinations of features as set out in the attached claims but also any other combination of features in the claims, wherein each feature mentioned in the claims can be combined with any other feature or combination of other features in the claims. Furthermore, any of the embodiments and features described or depicted herein can be claimed in a separate claim and/or in any combination with any embodiment or feature described or depicted herein or with any of the features of the attached claims.

In an embodiment in accordance with the invention, a pixel of a photo sensor may comprise: a portion of a first substrate comprising: a photodiode for detecting light, and a diffusion well associated with the photodiode to store charge from the photodiode, an amount of charge stored in the diffusion well dependent on duration and intensity of the light incident on the photodiode; a portion of a second substrate having a circuit for processing a signal from the first substrate; and a pixel level interconnect that connects the second well of the first substrate to the circuit of the second substrate to carry the signal from the diffusion well to the circuit.

The first substrate may comprise: a first transistor turned on during a non-exposure time of the pixel; and a second transistor turned on to transfer the photocharge stored in the photodiode to the well.

The first substrate may be P doped, and the diffusion well and the other diffusion well may be N doped.

The first substrate may have a front surface formed with the photodiode and the diffusion well facing the second substrate.

The second substrate may have a front surface formed with the circuitry and a rear surface at an opposite side of the second substrate, the front surface facing the first substrate.

The signal may be a voltage signal dependent on the amount of charge transferred from the photodiode to the diffusion well.

The processing may comprise at least one of sampling and analog-to-digital conversion.

In an embodiment in accordance with the invention, a method for operating a photo sensor may comprise: detecting light by a photodiode in a first substrate; storing charge from the photodiode by a diffusion well in the first substrate, the charge dependent on duration and intensity of light incident on the photodiode; generating a signal in the first substrate representing the charge stored in the diffusion well; sending the signal from the first substrate to the second substrate by a pixel-level interconnect that connects the diffusion well of the first substrate to a circuit of a second substrate; and processing the signal by the circuit in the second substrate.

The method may comprise: turning on a first transistor during a non-exposure time of the pixel; transferring charge from another diffusion well to the photodiode responsive to turning on the first transistor; and turning on a second transistor to transfer charge stored in the photodiode to the diffusion well.

The first substrate may be P doped, and the diffusion well and the other diffusion well may be N doped.

The first substrate may have a front surface formed with the photodiode and the diffusion well facing the second substrate.

The second substrate may have a front surface formed with the circuitry and a rear surface at an opposite side of the second substrate, the front surface facing the first substrate.

The signal may be a voltage signal dependent on the amount of charge transferred from the photodiode to the diffusion well.

The processing may comprise at least one of sampling and analog-to-digital conversion.

In a further embodiment of the invention, one or more computer-readable non-transitory storage media embody software that is operable when executed to perform in a system according to the invention or any of the above mentioned embodiments.

In a further embodiment of the invention, a computer-implemented method uses a system according to the invention or any of the above mentioned embodiments.

In a further embodiment of the invention, a computer program product, preferably comprising a computer-readable non-transitory storage media, is used in a system according to the invention or any of the above mentioned embodiments.

### BRIEF DESCRIPTION OF THE DRAWINGS

- FIG. 1: is a high-level block diagram illustrating the electronic device, according to one embodiment.
- FIG. 2: is a view illustrating the sensor architecture, according to one embodiment.
- FIG. 3: is a cross-sectional view illustrating the stacked photo assembly, according to one embodiment.
- FIG. 4: is a view illustrating the process flow of the stacked photo sensor assembly.

The figures depict various embodiments for purposes of illustration only. One skilled in the art will readily recognize from the following discussion that alternative embodiments of the structures and methods illustrated herein may be employed without departing from the principles described herein.

### DETAILED DESCRIPTION

Reference will now be made in detail to the preferred embodiment, an example of which is illustrated in the accompanying drawings. Whenever possible, the same reference numbers will be used throughout the drawings to refer to the same or like parts.

Embodiments relate to a stacked photo sensor assembly where two substrates that are stacked vertically. The two substrates are connected via interconnects at a pixel level to provide a signal from a photodiode at a first substrate to circuitry on a second substrate. The circuitry on the second substrate performs operations that were conventionally performed on first substrate. By stacking the first and second substrates, the photo sensor assembly can be made more compact while increasing or at least retaining the photodiode fill factor of the photo sensor assembly.

### Example System Architecture

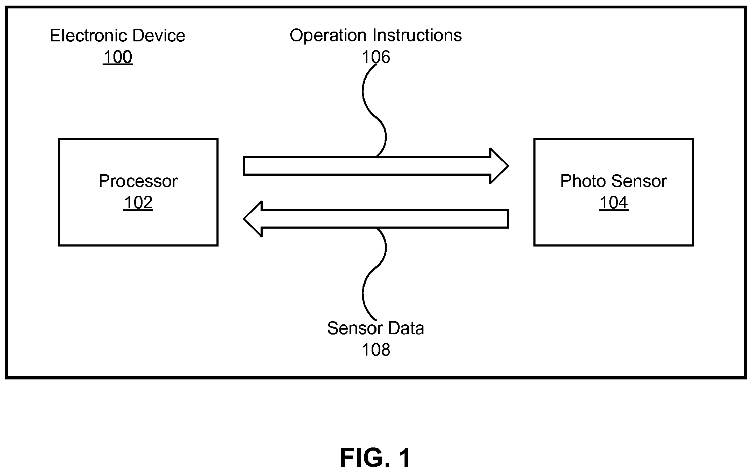

FIG. 1 is a high-level block diagram illustrating the electronic device, according to one embodiment. In one embodiment, the electronic device 100 includes, among other components, a processor 102 and a photo sensor 104 that are commutatively coupled. The electronic device 100 may include other components not illustrated in FIG. 1 such as memory and various other sensors.

The processor 102 is an electronic circuit that performs operations on a data source. The data source may include the photo sensor 104 that provides sensor data 108. The processor 102 generates operation instructions 106 that are sent to the photo sensor 104. The processing performed by the processor 102 may include an analog-digital conversion of the sensor data 108, which converts voltage analog signals or current analog signals into digital signals.

The photo sensor 104 is a circuit that measures light intensity and performs a photoconversion. Measuring light intensity may involve detecting light by a photodiode and the photoconversion may involve converting the light by the photodiode into a voltage or current signal.

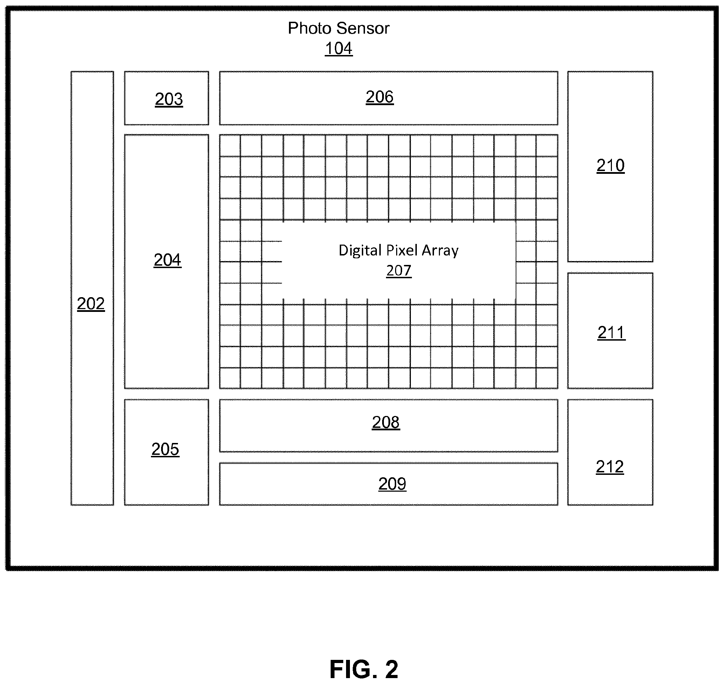

FIG. 2 is a schematic view illustrating the photo sensor 104, according to one embodiment. The photo sensor 104 includes, among other components, a digital block 202, a global counter 203, a row drivers and global signal drivers module 204, Mobile Industry Processor Interface (MIPI) 205, counter buffers 206, a digital pixel array 207, sense amplifiers 208, a line memory 209, a power conditioner 210, a ramp generation and buffers module 211, and a sense amplification biasing module 212.

The digital block 202 is a circuit that processes digital signals associated with the operation of the photo sensor 104. In one or more embodiments, at least part of the digital block 202 may be provided as part of the digital pixel array 207 instead of being a circuit separate from the digital pixel array 207.

The global counter 203 is a digital sequential logic circuit constructed of cascading flip-flops, and provides counter signals to various components of the photo sensor 104.

The row drivers and global signal drivers module 204 is a circuit that provides signals to rows of pixels via scan lines (not shown). The signal provided to each row of pixels indicates sensing of image signal and/or resetting operations at each row of pixels.

MIPI 205 is a serial interface for transmitting the sensor data 108 from the photo sensor 104 to the processor 102. An MIPI interface typically has a single clock lane and two data lanes (not shown) that carry serial data. These three lanes carry signals on pairs of wires where the signals are often differential.

The counter buffers 206 is a circuit that receives counter signals from the global counter 203, and sends signals to columns of pixels in the digital pixel array 207 to coordinate sensing and resetting operations.

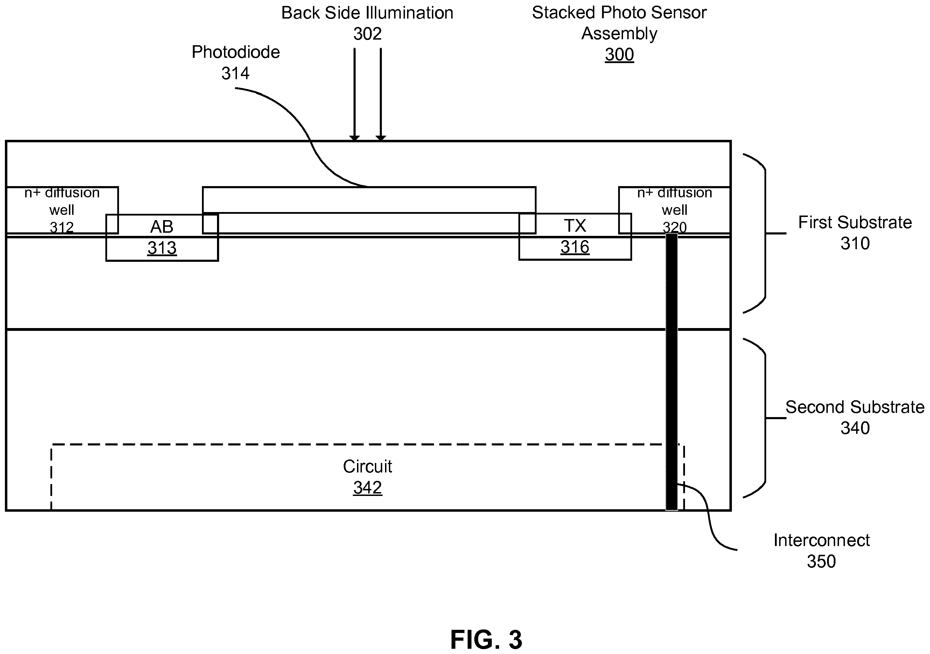

The digital pixel array 207 includes a plurality of pixels. In one embodiment, the digital pixel array is arranged in two dimensions, addressable by row and column. Each pixel is configured to sense light and output a signal corresponding to the intensity of the input light. Each pixel may include components as described below with reference to FIG. 3.

The sense amplifiers 208 are elements in the read circuitry that are used to the read out of the digital signals from the digital pixel array 207. The sense amplifiers 208 sense low power signals from a bitline that represents the intensity of light captured by the pixels in the digital pixel array 207. The sense amplifiers 208 may generate a digital output signal by utilizing an analog-to-digital converter (ADC). In one or more embodiments, at least part of the sense amplifiers 208 may be included in the digital pixel array 207.

The line memory 209 temporarily stores the sensed digital values of the light intensity detected at the digital pixel array 207, as sensed by the sense amplifiers 208 and processed by digital block 202 before sending the digital values to the processor 102 via MIPI 205 as the sensor data 108.

The power conditioner 210 is a circuit that improves the quality of the power that is delivered to components of the photo sensor 104. The power conditioner 210 may maintain and deliver a constant voltage that allows the components of the photo sensor 104 to function properly. In one embodiment, the power conditioner 210 is an AC power conditioner which smooths the sinusoidal AC waveform. In alternate embodiments, the power conditioner 210 is a power line conditioner which takes in power and modifies it based on the requirements of the components connected to the power line conditioner.

The ramp generator and buffers module 211 comprises a ramp generator and buffers. The ramp generator is a function generator that increases its voltage to a particular value. The ramp generator may be used to avoid jolts when changing a load. The buffers provide electrical impedance transformation from one circuit to another to prevent the ramp generator from being affected by the load.

The sense amplification biasing module 212 provides biasing voltage signal to the sense amplifiers 208. The biasing voltage signal is a predetermined voltage for the purpose of establishing proper operating conditions of the sense amplifiers 208 such as a steady DC voltage.

### Example Stacked Photo Sensor Assembly

FIG. 3 is a cross-sectional view illustrating the stacked photo sensor assembly 300, according to one embodiment. In one embodiment, the stacked photo assembly includes a first substrate 310 coupled to a second substrate 340. The first substrate 310 may be a back-side illumination 302 sensor that is flipped over and includes, among other components, a first n+ diffusion well 312, a photodiode 314, a transistor AB 313, a transistor TX 316, and a second n+ diffusion well 320.

Each of transistor AB 311 and transistor TX 316 includes an active layer, a drain electrode coupled to the active layer, a photodiode 314 that serves as a source of both transistor AB and transistor TX, an insulation layer over the active layer, and a gate electrode (not shown). By controlling a voltage level at the gates of the transistors AB 311 and the transistor TX 316, the transistors AB 311 and the transistor TX 316 can be turned on or off. The gates of these transistors receive signals from circuits external to the digital pixel array 207.

The first n+ diffusion well 312 is an N doped implant region formed in the first substrate 310. The first n+ diffusion well 312 receives photoelectrons that are transferred from the photodiode 314 when transistor AB 313 is turned on during non-exposure times. This is equivalent to a closed shutter mode in a traditional film camera. The transfer of photoelectrons from the photodiode 314 to the n+ diffusion well 312 ensures that no photoelectrons are accumulated on the photodiode 314, as the non-exposure times are periods when no signal is generated. The n+ diffusion well 312 is typically connected to a positive voltage source, for example VDD, so the photoelectrons are drained away. During an exposure time, which is equivalent to the shutter open mode in a film camera, both transistor AB 313 and transistor TX 316 are turned off and the photoelectrons are initially stored inside the photodiode 314. At the end of exposure, transistor TX 316 is turned on. As a result, the charge stored in the photodiode 314 is transferred to the second n+ diffusion well 320.

The photodiode 314 is a semiconductor device that converts light into an electric current. Current is generated when photons are absorbed in the photodiode 314. The photodiode 314 may be a p-n junction or PIN structure. When the intensity of light through back-side illumination 302 is higher, the amount of charge accumulated on the photodiode 314 is high. Similarly, when the intensity of light through back-side illumination 302 is lower, the amount of charge accumulated on the photodiode 314 is low.

The interconnect 350 may be a pixel level direct interconnect from n+ diffusion well 320 to a circuit 342 in the second substrate 340. In one embodiment, the interconnect 350 transmits a voltage signal that reflects the amount of charge transferred from the photodiode 314 to the n+ diffusion well 320. In alternative embodiments, the interconnect 350 transmits a current signal that reflects the amount of charge transferred from the photodiode 314 to the n+ diffusion well 320. The interconnect 350 carries the voltage signal to the circuit 342 for further processing such as sampling and analog-to-digital conversion. In still other embodiments, the stacked photo sensor assembly 300 may include additional interconnects that also transmit signals from the circuit 342 of the second substrate 340 to the first substrate 310. For example, signals for controlling transistor AB 313 and transistor TX 316 may be transmitted from the circuit 342 via these additional interconnects.

Embodiments move various circuit components provided on the first substrate 310 in conventional photo sensors to the second substrate 340, and connect the circuits of the second substrate 340 to the components in the first substrate 310 via the pixel level interconnect 350. The various circuit components moved to the second substrate 340 may include, among others, switches, amplifiers and current source. In this way, the area occupied by components in the first substrate 310 can be beneficially reduced and the fill factor can be increased.

### Example Process of Operation in Stacked Photo Sensor Assembly

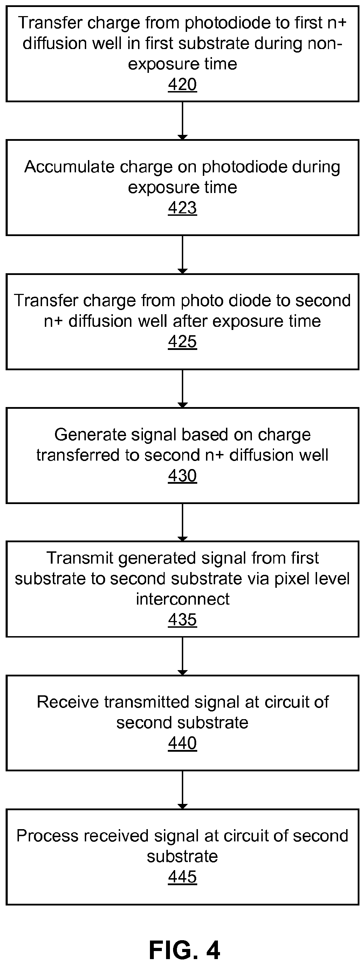

FIG. 4 is a view illustrating the process flow of the stacked photo sensor assembly. First, charge is transferred 420 from the photodiode 314 to the first n+ diffusion well 312 in the first substrate 310 during a non-exposure, or shutter close period. Specifically, transistor AB 313 is turned on to provide a current path between the first n+ diffusion well 312 and the photodiode 314. Second, during the exposure time, the shutter is open, and the charge is accumulated on the photodiode 314.

After the exposure time ends, charge accumulated in the photodiode 314 is transferred 425 to the second n+ diffusion 320. Specifically, transistor AB 313 is turned off, and transistor TX 316 is turned on to provide a current path to transfer the charge in the photodiode 314 to the second n+ diffusion well 320.

Based on the charge transferred to the second n+ well 320, a signal is generated 430 at the first substrate 310. The signal may be a voltage signal or a current signal.

The signal is then transmitted 435 from the first substrate 310 to the second substrate 340 stacked on the first substrate 310 via a pixel level interconnect 350.

The circuit 342 in the second substrate 340 receives 440 the signal transmitted over the interconnect 350. The circuit 342 processes 445 the received signal for sending to the processor 102.

The foregoing description of the embodiments has been presented for the purpose of illustration; it is not intended to be exhaustive or to limit the patent rights to the precise forms disclosed. Persons skilled in the relevant art can appreciate that many modifications and variations are possible in light of the above disclosure.

The language used in the specification has been principally selected for readability and instructional purposes, and it may not have been selected to delineate or circumscribe the patent rights. It is therefore intended that the scope of the patent rights be limited not by this detailed description, but rather by any claims that issue on an application based hereon. Accordingly, the disclosure of the embodiments is intended to be illustrative, but not limiting, of the scope of the patent rights, which is set forth in the following claims.

## Claims

1. A pixel of a photo sensor comprising:
a portion of a first substrate comprising:
a photodiode for detecting light, and
a diffusion well associated with the photodiode to store charge from the photodiode, an amount of charge stored in the diffusion well dependent on duration and intensity of the light incident on the photodiode;
a portion of a second substrate having a circuit for processing a signal from the first substrate; and
a pixel level interconnect that connects the second well of the first substrate to the circuit of the second substrate to carry the signal from the diffusion well to the circuit.

2. The pixel of a photo sensor according to claim 1, wherein the first substrate further comprises:
a first transistor turned on during a non-exposure time of the pixel; and
a second transistor turned on to transfer the photocharge stored in the photodiode to the well.

3. The pixel of a photo sensor according to claim 1 or 2, wherein the first substrate is P doped, and the diffusion well and the other diffusion well are N doped.

4. The pixel of a photo sensor according to any of claims 1 to 3, wherein the first substrate has a front surface formed with the photodiode and the diffusion well facing the second substrate.

5. The pixel of a photo sensor according to any of claims 1 to 4, wherein the second substrate has a front surface formed with the circuitry and a rear surface at an opposite side of the second substrate, the front surface facing the first substrate.

6. The pixel of a photo sensor according to any of claims 1 to 5, wherein the signal is a voltage signal dependent on the amount of charge transferred from the photodiode to the diffusion well.

7. The pixel of a photo sensor according to any of claims 1 to 6, wherein the processing comprises at least one of sampling and analog-to-digital conversion.

8. A method for operating a photo sensor, the method comprising:
detecting light by a photodiode in a first substrate;
storing charge from the photodiode by a diffusion well in the first substrate,
the charge dependent on duration and intensity of light incident on the photodiode;
generating a signal in the first substrate representing the charge stored in the diffusion well;
sending the signal from the first substrate to the second substrate by a pixel-level interconnect that connects the diffusion well of the first substrate to a circuit of a second substrate; and
processing the signal by the circuit in the second substrate.

9. The method according to claim 8, further comprising:
turning on a first transistor during a non-exposure time of the pixel;
transferring charge from another diffusion well to the photodiode responsive to turning on the first transistor; and
turning on a second transistor to transfer charge stored in the photodiode to the diffusion well.

10. The method according to claim 8 or 9, wherein the first substrate is P doped, and the diffusion well and the other diffusion well are N doped.

11. The method according to any of claims 8 to 10, wherein the first substrate has a front surface formed with the photodiode and the diffusion well facing the second substrate.

12. The method according to any of claims 8 to 11, wherein the second substrate has a front surface formed with the circuitry and a rear surface at an opposite side of the second substrate, the front surface facing the first substrate.

13. The method according to any of claims 8 to 12, wherein the signal is a voltage signal dependent on the amount of charge transferred from the photodiode to the diffusion well.

14. The method according to any of claims 8 to 13, wherein the processing comprises at least one of sampling and analog-to-digital conversion.
